# EUROPEAN PATENT APPLICATION

(11) **EP 4 765 660 A1**
(43) Date of publication of application: **24.06.2026**
(21) Application number: 24870820.8
(22) Date of filing: 25.09.2024
(51) Int. Cl.: H04B 7/0413, H01P 1/32

(54) **RADIO-FREQUENCY POWER AMPLIFIER MODULE, MANUFACTURING METHOD, ANTENNA TRANSCEIVING MODULE, AND BASE STATION**

(30) Priority: 28.09.2023 CN 202311283647
(71) Applicant: HUAWEI TECHNOLOGIES CO., LTD., Shenzhen 518129 (CN)
(72) Inventor: YAN, Qingwei, Shenzhen, Guangdong 518129 (CN); YANG, Guanqiao, Shenzhen, Guangdong 518129 (CN); SUN, Jie, Shenzhen, Guangdong 518129 (CN); HUANG, Shujun, Shenzhen, Guangdong 518129 (CN); ZHANG, Ru, Shenzhen, Guangdong 518129 (CN)
(74) Representative: Gill Jennings & Every LLP
(86) International application number: PCT/CN2024/121224
(87) International publication number: WO 2025/067276

(57) **Abstract**

Embodiments of this application provide a radio-frequency power amplifier module, a manufacturing method, an antenna transceiver module, and a base station, and relate to the field of communication device technologies. The radio-frequency power amplifier module includes: a first substrate, and a power amplifier component and an isolation component that are provided on the first substrate, where the power amplifier component is electrically connected to the isolation component through the first substrate; and the isolation component includes a ferrite element and a first region of the first substrate, and the ferrite element is provided in the first region of the first substrate. Embodiments of this application can effectively decrease costs of the radio-frequency power amplifier module, reduce an area of the radio-frequency power amplifier module, reduce an insertion loss between the power amplifier component and the isolation component, and improve transmission efficiency of a transmit path.

## Description

This application claims priority to Chinese Patent Application No. 202311283647.5, filed with the China National Intellectual Property Administration on September 28, 2023 and entitled "RADIO-FREQUENCY POWER AMPLIFIER MODULE, MANUFACTURING METHOD, ANTENNA TRANSCEIVER MODULE, AND BASE STATION", which is incorporated herein by reference in its entirety.

### TECHNICAL FIELD

This application relates to the field of communication device technologies, and in particular, to a radio-frequency power amplifier module, a manufacturing method, an antenna transceiver module, and a base station.

### BACKGROUND

With the development of mobile communication technologies, massive multiple-input multiple-output (massive multiple in multiple out, Massive MIMO) systems are usually employed to ensure coverage capabilities of base stations. Therefore, a large quantity of radio-frequency power amplifier modules need to be provided in a massive MIMO system. However, existing radio-frequency power amplifier modules cannot meet requirements of miniaturization and low costs.

### SUMMARY

Embodiments of this application provide a radio-frequency power amplifier module, a manufacturing method, an antenna transceiver module, and a base station, to reduce an area of the radio-frequency power amplifier module, decrease costs, and improve transmission efficiency of a transmit path.

To achieve the foregoing objectives, the following technical solutions are used in embodiments of this application.

According to a first aspect, a radio-frequency power amplifier module is provided. The radio-frequency power amplifier module includes: a first substrate, and a power amplifier component and an isolation component that are provided on the first substrate, where the power amplifier component is electrically connected to the isolation component through the first substrate; and the isolation component includes a ferrite element and a first region of the first substrate, and the ferrite element is provided in the first region of the first substrate.

In an implementation of this application, in the radio-frequency power amplifier module, the ferrite element in the isolation component is directly provided in the first region of the first substrate, a first connection circuit may be provided in the first region of the first substrate, and the first connection circuit is configured to be electrically connected to a remaining part of the isolation component, for example, the ferrite element. In other words, the first substrate replaces a support substrate that is provided when the isolation component is a discrete component, thereby effectively decreasing costs of the radio-frequency power amplifier module. In addition, there is no need to consider packaging avoidance of the isolation component, so that a cabling distance between the isolation component and the power amplifier component can be shortened. In this way, an area of the radio-frequency power amplifier module is reduced, an insertion loss between the power amplifier component and the isolation component is reduced, and transmission efficiency of a transmit path is improved.

In some possible implementations, the power amplifier component includes a power amplifier chip and a second region of the first substrate, and the power amplifier chip is provided in the second region of the first substrate.

In this implementation, the power amplifier component includes the power amplifier chip and the second region of the first substrate, the power amplifier chip is provided in the second region of the first substrate, a second connection circuit may be provided in the second region of the first substrate, and the power amplifier component is electrically connected to the isolation component through the second connection circuit. In other words, the first substrate replaces a package substrate that is provided when the power amplifier component is a discrete component, thereby effectively decreasing costs of the radio-frequency power amplifier module. In addition, the power amplifier component and the isolation component can be integrated on the first substrate, and there is no need to consider packaging avoidance between the power amplifier component and the isolation component, so that a cabling distance between the isolation component and the power amplifier component is further shortened. In this way, an area of the radio-frequency power amplifier module is reduced, an insertion loss between the power amplifier component and the isolation component is reduced, and transmission efficiency of a transmit path is improved.

In some possible implementations, the isolation component further includes a dielectric unit, the dielectric unit is of a ring structure, and the dielectric unit is nested around the ferrite element. The dielectric unit can optimize a magnetic circuit.

In some possible implementations, the isolation component further includes a magnet element, the magnet element is provided on a side of the ferrite element, and a projection of the magnet element on the first substrate at least partially overlaps a projection of the ferrite element on the first substrate. The magnet element is configured to provide a magnetic field, so that an input radio-frequency signal can flow only in a specific direction.

In some possible implementations, the radio-frequency power amplifier module further includes a second substrate, the second substrate is located on a side of the first substrate away from the power amplifier component, and the second substrate is electrically connected to the first substrate. Performance of the second substrate may be lower than performance of the first substrate, thereby decreasing costs of the radio-frequency power amplifier module.

In some possible implementations, the radio-frequency power amplifier module further includes a heat dissipation layer, and the heat dissipation layer is located on a side of the first substrate away from the power amplifier component, to assist the power amplifier component in heat dissipation.

In some possible implementations, the radio-frequency power amplifier module further includes a heat dissipation layer, and the heat dissipation layer is located on a side of the power amplifier component away from the first substrate, to assist the power amplifier component in heat dissipation.

In some possible implementations, the magnet element is embedded in the second substrate.

In some possible implementations, the magnet element is embedded in the heat dissipation layer.

In some possible implementations, the magnet element is embedded in the first substrate, and is provided on a side of the ferrite element close to the first substrate.

In some possible implementations, the ferrite element and the power amplifier component are provided on the first substrate, and are located on a same side of the first substrate.

In some possible implementations, the ferrite element is embedded in the first substrate.

In some possible implementations, the ferrite element is embedded in the first substrate, and a coating layer is provided on the ferrite element.

In some possible implementations, the power amplifier component further includes an input matching circuit and an output matching circuit. The input matching circuit and the output matching circuit are provided in the second region of the first substrate. An input end of the power amplifier chip is electrically connected to the input matching circuit, and an output end of the power amplifier chip is electrically connected to the output matching circuit.

In some possible implementations, the power amplifier component includes a power amplifier chip, an input matching circuit, an output matching circuit, and a package substrate. The power amplifier chip, the input matching circuit, and the output matching circuit are provided on the package substrate. An input end of the power amplifier chip is electrically connected to the input matching circuit, and an output end of the power amplifier chip is electrically connected to the output matching circuit.

According to a second aspect, a manufacturing method for a radio-frequency power amplifier module is provided. The manufacturing method for a radio-frequency power amplifier module includes: separately forming a first substrate, a power amplifier component, and an isolation component, where the first substrate includes a first region, the isolation component includes a ferrite element, and the ferrite element is provided in the first region of the first substrate; and electrically connecting the power amplifier component to the first substrate.

According to a third aspect, an antenna transceiver module is provided. The antenna transceiver module includes a receive path, a transmit path, and an antenna. The transmit path is electrically connected to the receive path and the antenna, and the transmit path includes the radio-frequency power amplifier module provided in the first aspect.

According to a fourth aspect, a base station is provided. The base station includes a baseband processing unit, a digital-to-analog conversion unit, and at least one antenna transceiver module provided in the third aspect, where the baseband processing unit is connected to the antenna transceiver module through the digital-to-analog conversion unit.

For technical effects achieved by any one of the possible implementations of the second aspect to the fourth aspect, refer to technical effects achieved by different implementations of the first aspect. Details are not described herein again.

### BRIEF DESCRIPTION OF DRAWINGS

To describe the technical solutions in embodiments of the present invention more clearly, the following briefly describes the accompanying drawings needed for describing embodiments. It is clear that the accompanying drawings in the following descriptions show merely some embodiments of the present invention, and a person of ordinary skill in the art may derive other drawings from these accompanying drawings without creative efforts.
FIG. 1 is a diagram of a structure of a base station according to some embodiments of this application;
FIG. 2 is a circuit diagram of an antenna transceiver module in a base station according to some embodiments of this application;
FIG. 3A to FIG. 3C are a diagram of a structure of a radio-frequency power amplifier module according to some embodiments of this application;
FIG. 4 is a diagram of a structure of an isolation component according to some embodiments of this application;
FIG. 5 is a diagram of a structure of a radio-frequency power amplifier module according to some other embodiments of this application;
FIG. 6 is a diagram of a three-dimensional structure of a radio-frequency power amplifier module according to some embodiments of this application;
FIG. 7 is a flowchart of a manufacturing method for a radio-frequency power amplifier module according to some embodiments of this application;
FIG. 8A to FIG. 8C are a diagram of a structure of an isolation component according to some embodiments of this application;
FIG. 9A and FIG. 9B are a diagram of a structure of an isolation component according to some embodiments of this application;
FIG. 10 is a diagram of a structure of a radio-frequency power amplifier module according to some embodiments of this application;
FIG. 11A to FIG. 11C are a diagram of a structure of a radio-frequency power amplifier module according to some other embodiments of this application;
FIG. 12A and FIG. 12B are a diagram of a structure of a radio-frequency power amplifier module according to some other embodiments of this application;
FIG. 13A to FIG. 13C are a diagram of a structure of a radio-frequency power amplifier module according to some other embodiments of this application;
FIG. 14A, FIG. 14B, FIG. 14C, FIG. 14D, and FIG. 14E are a diagram of a structure of a radio-frequency power amplifier module according to some other embodiments of this application;
FIG. 15A and FIG. 15B are a diagram of a structure of a radio-frequency power amplifier module according to some other embodiments of this application;
FIG. 16 is a diagram of a structure of a radio-frequency power amplifier module according to some other embodiments of this application;
FIG. 17 is a diagram of a structure of a radio-frequency power amplifier module according to some other embodiments of this application;
FIG. 18 is a diagram of a structure of a radio-frequency power amplifier module according to some other embodiments of this application;
FIG. 19 is a circuit diagram of an antenna transceiver module according to some embodiments of this application; and
FIG. 20 is a diagram of a structure of a base station according to some embodiments of this application.

### DESCRIPTION OF EMBODIMENTS

The following describes the technical solutions in embodiments of this application with reference to the accompanying drawings in embodiments of this application. It is clear that the described embodiments are merely some rather than all of embodiments of this application.

In embodiments of this application, the terms "first" and "second" are used merely for a purpose of description, and shall not be construed as indicating or implying relative importance or implying a quantity of indicated technical features. Therefore, a feature limited by "first" or "second" may explicitly or implicitly include one or more features.

In embodiments of this application, the term "connection" refers to coupling, including direct connection or indirect connection through another component to implement electrical connection.

A base station is a radio transceiver station that exchanges information with user equipment through a mobile communication switching center within a radio coverage area. With the development of mobile communication technologies, a radio transmission speed is improved. However, as a signal frequency band increases, a loss also increases, resulting in a weaker coverage capability of the base station.

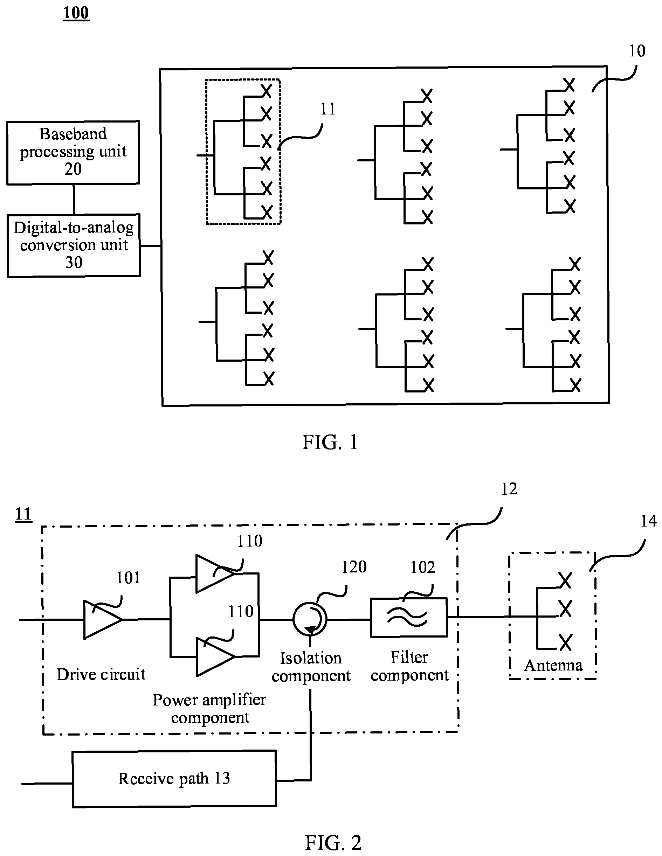

To ensure the coverage capability of the base station, the base station needs to use a massive multiple-input multiple-output (massive multiple-input multiple-output, Massive MIMO) antenna transceiver system to obtain a beamforming gain and improve the coverage capability of the base station. FIG. 1 is a diagram of a structure of a base station according to some embodiments of this application. The base station 100 includes a baseband processing unit 20, a digital-to-analog conversion unit 30, and a multiple-input multiple-output antenna transceiver system 10. The digital-to-analog conversion unit 30 is configured to convert a digital baseband signal sent by the baseband processing unit 20 into a radio-frequency small signal, and send the radio-frequency small signal to the multiple-input multiple-output antenna transceiver system 10. The multiple-input multiple-output antenna transceiver system 10 is configured to amplify the radio-frequency small signal into a radio-frequency signal, and send the radio-frequency signal to another base station or user equipment. The multiple-input multiple-output antenna transceiver system 10 is further configured to receive a radio-frequency signal sent by another base station or user equipment, and send the received radio-frequency signal to the digital-to-analog conversion unit 30. The digital-to-analog conversion unit 30 is further configured to convert the radio-frequency signal into a digital signal and send the digital signal to the baseband processing unit 20 for processing. The multiple-input multiple-output antenna transceiver system 10 includes a plurality of antenna transceiver modules 11. As shown in FIG. 2, the antenna transceiver module 11 includes a transmit path 12, a receive path 13, and an antenna 14, and the transmit path 12 is separately connected to the receive path 13 and the antenna 14. The transmit path 12 includes a drive circuit 101, power amplifier components 110, an isolation component 120, and a filter component 102. For example, the isolation component 120 may be a circulator (circulator, Cir) or an isolator (isolator, Iso). The isolation component 120 is a three-port component. A first port of the isolation component 120 is electrically connected to the power amplifier component 110, a second port of the isolation component 120 is electrically connected to the filter component 102, and a third port of the isolation component 120 is electrically connected to the receive path 13.

A radio-frequency small signal is amplified by the drive circuit 101 and the power amplifier component 110 level by level into a radio-frequency signal, to ensure that a level of the radio-frequency signal meets a preset power level value. The radio-frequency signal obtained through amplification has features such as high power, high efficiency, and low distortion, to achieve an optimal transmission effect. The isolation component 120 serves to provide isolation, so as to prevent an interference signal reflected from a load end, such as the filter component 102 or the antenna 14, from affecting performance of the power amplifier component 110, and reduce impact of a reflected signal on a digital pre-distortion (digital pre-distortion, DPD) forward correction signal. Finally, because there are some unnecessary harmonics in an output of the power amplifier component 110, the filter component 102 needs to be used for filtering, so that the radio-frequency signal is transmitted by the antenna 14 after passing through the filter component 102 in a forward direction, thereby avoiding interference to a peripheral device.

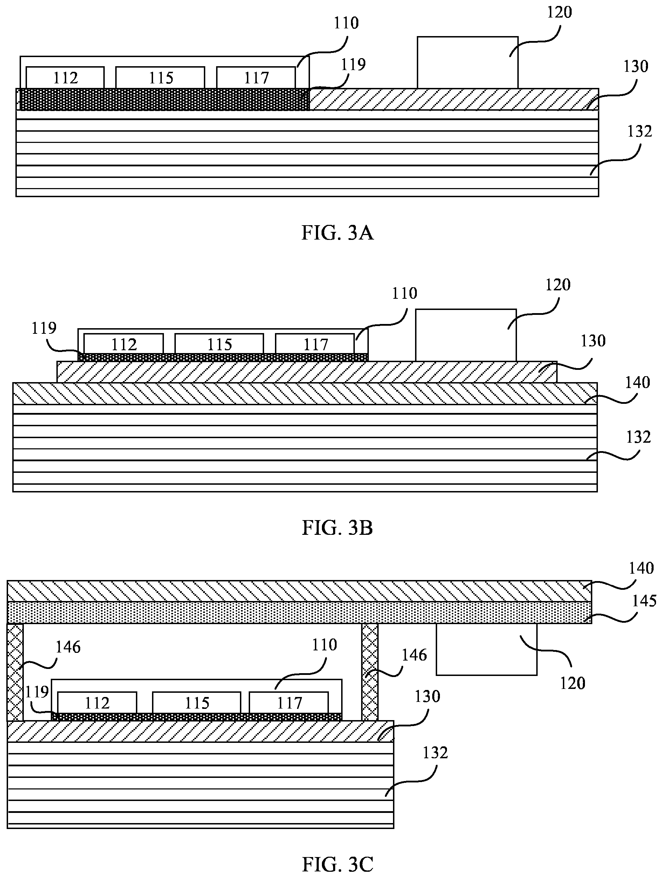

In some optional examples, the power amplifier component 110 and the isolation component 120 may be considered as one radio-frequency power amplifier module. Refer to a diagram of a structure of a radio-frequency power amplifier module shown in FIG. 3A to FIG. 3C. The radio-frequency power amplifier module is classified into a metal-substrate power amplifier module, a castellated power amplifier module, and an inverted power amplifier module.

The metal-substrate power amplifier module shown in FIG. 3A further includes a heat dissipation layer 132 and a first substrate 130 provided on the heat dissipation layer 132. For example, the heat dissipation layer 132 is a heat sink (heat sink, HS) layer, and the first substrate 130 is a power amplifier board (power amplifier board, PA Board). The power amplifier component 110 and the isolation component 120 are discrete components, and then the power amplifier component 110 and the isolation component 120 are assembled on the first substrate 130 by using a surface mount technology (surface mount technology, SMT). A radio-frequency matching circuit is formed in the first substrate 130. The radio-frequency matching circuit is configured to match impedance between an output end of the power amplifier component 110 and an input end of the isolation component 120, and the power amplifier component 110 and the isolation component 120 are electrically connected through the radio-frequency matching circuit, to form the radio-frequency power amplifier module.

It may be understood that, that the power amplifier component 110 and the isolation component 120 are discrete components means that the power amplifier component 110 and the isolation component 120 are electronic components that are independently manufactured and used, and each is an electronic component that implements a specific function by using a single physical component, instead of being integrated on one chip.

In some optional examples, the power amplifier component 110 includes an input matching circuit 112, a power amplifier chip 115, an output matching circuit 117, and a flange structure 119. The input matching circuit 112, the power amplifier chip 115, and the output matching circuit 117 may be integrated on the flange structure 119. An input end of the power amplifier chip 115 is electrically connected to the input matching circuit 112, and an output end of the power amplifier chip 115 is electrically connected to the output matching circuit 117. Correspondingly, a hollow portion is provided on the first substrate 130, so that the flange structure 119 of the power amplifier component is embedded in the first substrate 130, and heat energy generated by the power amplifier chip 115 is directly transferred to the heat dissipation layer 132 through the flange structure 119. It may be understood that the power amplifier component 110 may further include a package substrate, and the input matching circuit 112 and the output matching circuit 117 are electrically connected to the package substrate, so that the power amplifier component 110 can be used independently.

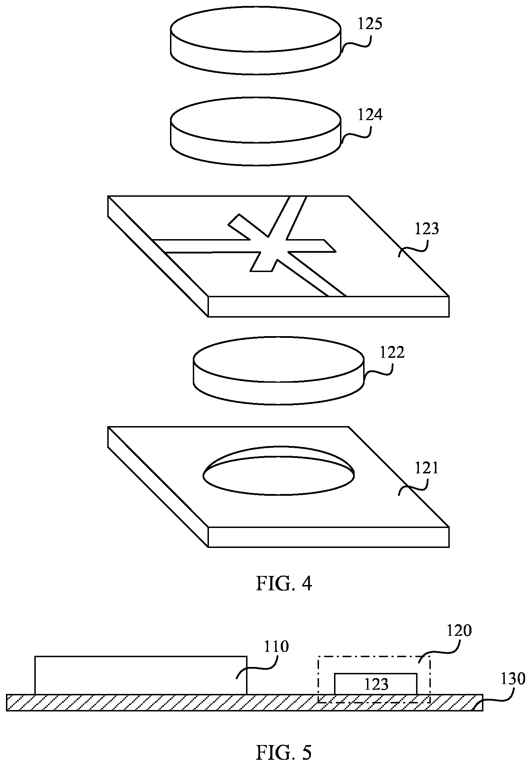

Refer to a diagram of a structure of an isolation component shown in FIG. 4. The isolation component 120 includes a support substrate 121, a magnetic uniformity element 122, a ferrite element 123, a ceramic element 124, and a magnet element 125 that are provided in a stacked manner. A conductive structure is provided in the support substrate 121, and is configured to connect other elements of the isolation component 120. In addition, the conductive structure may implement signal transmission and coupling, so that the isolation component 120 can complete a directional coupling function. The magnetic uniformity element 122 keeps a uniform magnetic field inside the isolation component 120, to ensure performance and stability of the isolation component 120. The ferrite element 123 serves as a magnetic core in the isolation component 120, and can effectively concentrate, focus, and guide magnetic fields to another part of the isolation component 120, to implement directional coupling and transmission of a signal. The ceramic element 124 may enhance performance of the isolation component 120, and the magnet element 125 is configured to form a magnetic field inside the isolation component 120.

Because the radio-frequency matching circuit needs to be formed in the first substrate 130, materials with good high-frequency performance need to be used for the first substrate 130, for example, high-frequency glass-fiber reinforced polymer (FR-4) or polytetrafluoroethylene (PTFE). These materials have a low dielectric loss and good insulation performance, and can reduce signal attenuation and crosstalk, but result in high costs. Therefore, in the castellated power amplifier module shown in FIG. 3B, on the basis of the metal-substrate power amplifier module shown in FIG. 3A, a second substrate 140 is further provided between a heat dissipation layer 132 and a first substrate 130. For example, the second substrate 140 is a transceiver printed circuit board (transmission receiver printed circuit board, TRX PCB). Therefore, a radio-frequency matching circuit may be formed on the first substrate 130, and another circuit, such as an intermediate frequency circuit and a modem circuit, may be formed on the second substrate 140. An area of the first substrate 130 in the castellated power amplifier module is less than an area of the first substrate 130 in the metal-substrate power amplifier module, and therefore, costs can be decreased.

To further reduce a volume of the radio-frequency power amplifier module, the inverted power amplifier module shown in FIG. 3C includes a heat dissipation layer 132, and a first substrate 130, a third substrate 145, and a second substrate 140 that are provided on the heat dissipation layer 132 in a stacked manner. A power amplifier component 110 is provided on the first substrate 130. Because the first substrate 130 is electrically isolated from the third substrate 145, a conductive structure 146 is further provided between the first substrate 130 and the third substrate, so that the first substrate 130 is electrically connected to the third substrate 145. An isolation component 120 is provided on the third substrate 145 and is provided on a side of the third substrate 145 close to the first substrate 130, and a projection of the isolation component 120 on the first substrate 130 does not overlap a projection of the power amplifier component 110 on the first substrate 130.

In all the foregoing three types of radio-frequency power amplifier modules, an output of the power amplifier component 110 is first matched to 50-ohm impedance or a specific impedance value near 50 ohms, and matching design is performed on impedance of a first port of the isolation component 120 based on output impedance of the power amplifier component 110, to ensure a small cascading standing wave as much as possible, and implement radio-frequency transmission without a power loss or a low power loss. A reflected signal is isolated by using a second port of the isolation component 120, to avoid impact of the reflected signal on performance of the power amplifier component 110.

However, the foregoing three types of radio-frequency power amplifier modules have the following problems: (1) A layout area of the first substrate 130 is large, and packaging avoidance between the power amplifier component 110 and the isolation component 120 occupies a certain area, which is unfavorable for miniaturization. (2) A cabling insertion loss between the power amplifier component 110 and the isolation component 120 causes an extra power loss. (3) In a massive multiple-input multiple-output antenna transceiver system, costs of a large quantity of discrete isolation components 120 are high. (4) Due to assembly tolerances and tolerances of isolation devices from a plurality of manufacturers, radio-frequency consistency issues are prominent, and digital resource overheads in a system need to be decreased urgently, particularly in a "one-drive-N" system.

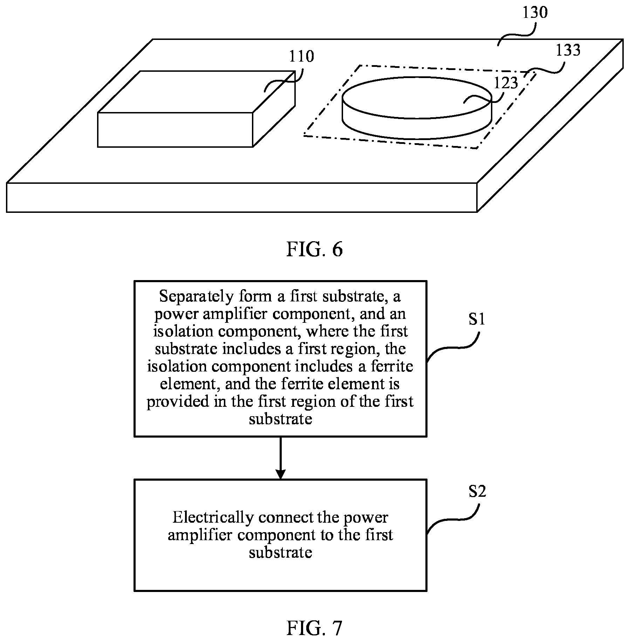

Therefore, embodiments of this application further provide a radio-frequency power amplifier module. Refer to diagrams of structures of a radio-frequency power amplifier module shown in FIG. 5 and FIG. 6. The radio-frequency power amplifier module includes: a first substrate 130, and a power amplifier component 110 and an isolation component 120 that are provided on the first substrate 130, where the power amplifier component 110 is electrically connected to the isolation component 120 through the first substrate 130; and the isolation component 120 includes a ferrite element 123 and a first region 133 of the first substrate 130, and the ferrite element 123 is provided in the first region 133 of the first substrate 130.

As shown in FIG. 7, a process of forming the radio-frequency power amplifier module includes: S1: separately forming a first substrate 130, a power amplifier component 110, and an isolation component 120, where the first substrate 130 includes a first region 133, the isolation component 120 includes a ferrite element 123, and the ferrite element 123 is provided in the first region 133 of the first substrate 130; and S2: electrically connecting the power amplifier component 110 to the first substrate 130.

In this embodiment of this application, the ferrite element 123 in the isolation component 120 is directly provided in the first region 133 of the first substrate 130, a first connection circuit may be provided in the first region 133 of the first substrate 130, and the first connection circuit is configured to be electrically connected to a remaining part of the isolation component 120, for example, the ferrite element 123. In other words, the first substrate 130 replaces the support substrate in the isolation component 120 in the foregoing embodiment, thereby effectively decreasing costs of the radio-frequency power amplifier module. In addition, there is no need to consider packaging avoidance of the isolation component, so that a cabling distance between the isolation component and the power amplifier component 110 can be shortened. In this way, an area of the radio-frequency power amplifier module is reduced, an insertion loss between the power amplifier component 110 and the isolation component 120 is reduced, and transmission efficiency of a transmit path is improved.

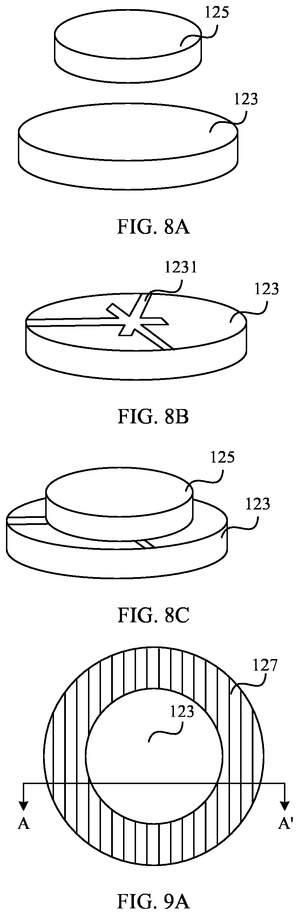

In an optional embodiment, the isolation component 120 further includes a magnet element 125, and the magnet element 125 is provided above the ferrite element 123 in a stacked manner. For example, the magnet element 125 is a permanent magnet element. Correspondingly, refer to a diagram of a structure of the isolation component at each forming stage shown in FIG. 8A to FIG. 8C. A process of forming the isolation component 120 is: separately forming the ferrite element 123 and the magnet element 125, where the ferrite element 123 and the magnet element 125 may be of a same shape or may be of different shapes, which is not limited in this embodiment of this application, for example, both the ferrite element 123 and the magnet element 125 are cylindrical; or the ferrite element 123 is cubic, and the magnet element 125 is cylindrical; then, forming a corresponding circuit pattern 1231 on a surface of the ferrite element 123, and curing the pattern by coating silver paste and sintering; and finally, bonding the ferrite element 123 formed with the circuit pattern to the magnet element 125, that is, forming the isolation component 120 including the ferrite element 123 and the magnet element 125. The magnet element 125 may provide a magnetic field, so that an input radio-frequency signal can flow only in a specific direction.

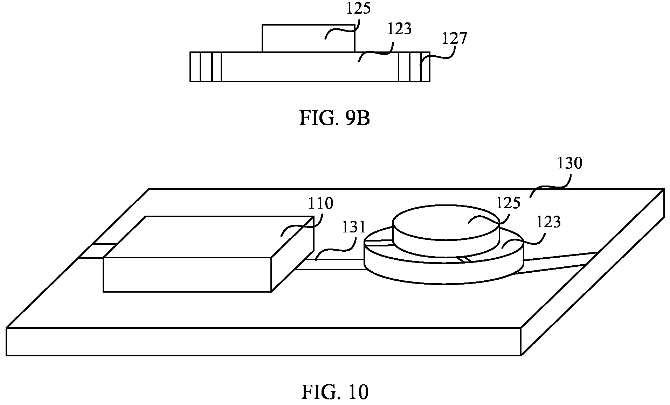

In an optional embodiment, as shown in FIG. 9A and FIG. 9B, FIG. 9B shows a cross-sectional view of FIG. 9A along AA'. The isolation component 120 further includes a dielectric unit 127. The dielectric unit 127 is of a ring structure, and the dielectric unit is nested around the ferrite element 123, so that a magnetic circuit inside the isolation component can be optimized.

In an optional embodiment, refer to a diagram of a structure of a radio-frequency power amplifier module shown in FIG. 10. A radio-frequency matching circuit 131 is provided in the first substrate 130, and the radio-frequency matching circuit 131 is configured to match output impedance of the power amplifier component 110 to input impedance of the isolation component 120. For example, a 50-ohm microstrip may be used for the radio-frequency matching circuit 131, and there is a reserved tuning network around the microstrip, so that a single radio-frequency matching circuit 131 is tunable. The power amplifier component 110 is electrically connected to the isolation component 120 through the radio-frequency matching circuit 131. For example, an input end of the radio-frequency matching circuit 131 is electrically connected to an output end of the power amplifier component 110, and an output end of the radio-frequency matching circuit 131 is directly electrically connected to a first connection circuit provided in the first region 133 that is of the first substrate 130 and that is in the isolation component 120, so that a cabling distance between the isolation component 120 and the power amplifier component 110 can be shortened. In this way, an area of the radio-frequency power amplifier module is reduced, an insertion loss between the power amplifier component 110 and the isolation component 120 is reduced, and performance of a radio-frequency channel between the single power amplifier component 110 and the isolation component 120 is adjustable, thereby ensuring radio-frequency performance consistency between a plurality of channels, facilitating integration design with a massive MIMO system, and reducing a requirement for digital chip resources.

The following further describes the radio-frequency power amplifier module in the foregoing embodiments by using a castellated power amplifier module as an example.

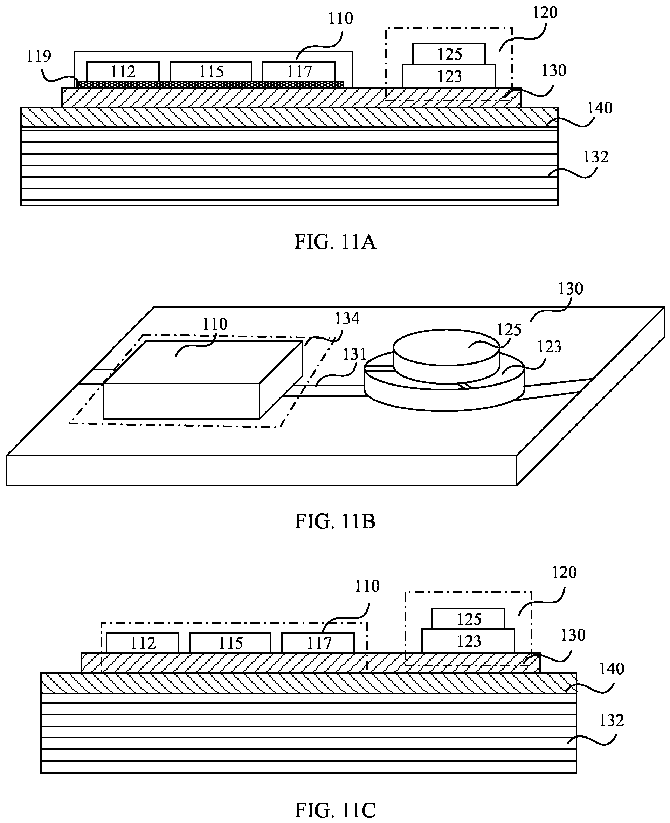

Refer to a diagram of a structure of a radio-frequency power amplifier module shown in FIG. 11A. The castellated radio-frequency power amplifier module includes a heat dissipation layer 132, and a second substrate 140 and a first substrate 130 that are provided on the heat dissipation layer 132 in a stacked manner. A power amplifier component 110 and an isolation component 120 are provided on the first substrate 130. The power amplifier component 110 is electrically connected to the isolation component 120 through the first substrate 130. The isolation component 120 includes a ferrite element 123, a magnet element 125, and a first region 133 of the first substrate 130. The magnet element 125 is provided on the ferrite element 123 in a stacked manner. The ferrite element 123 is provided on an upper surface of the first region 133 of the first substrate 130. A first connection circuit is provided in the first region 133 of the first substrate 130, and the first connection circuit is configured to be connected to another part of the isolation component, for example, the first connection circuit is electrically connected to the ferrite element 123.

In an optional example, the power amplifier component 110 is a discrete component, for example, the power amplifier component 110 shown in FIG. 11A. To be specific, the power amplifier component 110 includes an input matching circuit 112, a power amplifier chip 115, an output matching circuit 117, a flange structure 119, and a package substrate. The input matching circuit 112, the power amplifier chip 115, and the output matching circuit 117 may be provided on the flange structure 119, so that the flange structure 119 may assist the input matching circuit 112, the power amplifier chip 115, and the output matching circuit 117 in heat dissipation. An input end of the power amplifier chip 115 is electrically connected to the input matching circuit 112, and an output end of the power amplifier chip 115 is electrically connected to the output matching circuit 117. A second connection circuit is provided in the package substrate, and the second connection circuit is configured to be connected to all circuits of the power amplifier component 110, for example, the second connection circuit is electrically connected to the input matching circuit 112 and the output matching circuit 117. The second connection circuit is further electrically connected to a radio-frequency matching circuit 131 in the first substrate 130, so that a radio-frequency signal output by the output matching circuit 117 can be sent to the radio-frequency matching circuit 131.

However, packaging of the power amplifier component 110 also occupies an area of the first substrate 130. Therefore, to further miniaturize the radio-frequency power amplifier module, in an optional example, refer to a diagram of a three-dimensional structure of a radio-frequency power amplifier module shown in FIG. 11B and a schematic cross-sectional view of the radio-frequency power amplifier module shown in FIG. 11C. The power amplifier component 110 is an integrated component. To be specific, the power amplifier component includes an input matching circuit 112, a power amplifier chip 115, an output matching circuit 117, and a second region 134 of the first substrate 130. A second connection circuit is provided in the second region 134 of the first substrate 130. The input matching circuit 112 and the output matching circuit 117 are electrically connected to the second connection circuit provided in the second region 134 of the first substrate 130. The second connection circuit is further directly electrically connected to a radio-frequency matching circuit 131 in the first substrate 130. In other words, the first substrate 130 replaces the package substrate. In another optional example, the first substrate may further replace the flange structure 119, and assist the input matching circuit 112, the power amplifier chip 115, and the output matching circuit 117 in heat dissipation, thereby effectively decreasing costs of the radio-frequency power amplifier module. In addition, the power amplifier component 110 and an isolation component 120 can be integrated on the first substrate 130, and there is no need to consider packaging avoidance between the power amplifier component 110 and the isolation component 120, so that a cabling distance between the isolation component and the power amplifier component 110 is further shortened. In this way, an area of the radio-frequency power amplifier module is reduced, an insertion loss between the power amplifier component 110 and the isolation component 120 is reduced, and transmission efficiency of a transmit path is improved.

It may be understood that the foregoing examples are merely examples for better understanding of the technical solutions in embodiments of this application, and are not intended to limit embodiments of this application. The ferrite element 123 in embodiments of this application is not limited to being provided on a surface of the first substrate 130.

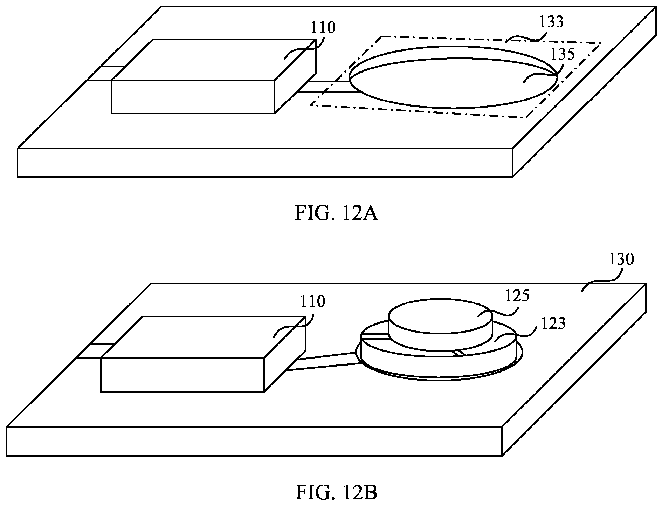

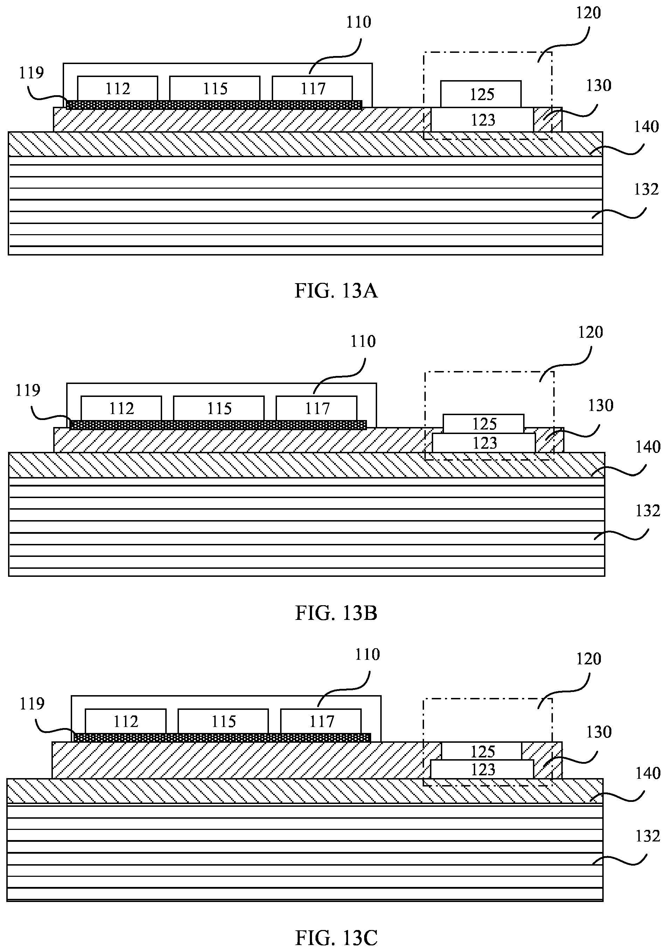

In an optional example, as shown in a diagram of a structure of a radio-frequency power amplifier module in FIG. 12A, the ferrite element 123 may be alternatively embedded in the first substrate 130. A hollow portion 135 is provided in the first region 133 of the first substrate 130, and the hollow portion 135 may at least accommodate a part of the ferrite element 123, so that the ferrite element 123 is embedded in the first substrate 130, to form the radio-frequency power amplifier module shown in FIG. 12B. For example, a depth of the hollow portion 135 is less than or equal to a height of the ferrite element 123, to form a structure of a radio-frequency power amplifier module shown in FIG. 13A, where at least a part of the ferrite element 123 is embedded in the first substrate 130; or a depth of the hollow portion 135 is greater than a height of the ferrite element 123, but is less than a total height of the ferrite element 123 and the magnet element 125, to form a structure of a radio-frequency power amplifier module shown in FIG. 13B, where the entire ferrite element 123 and a part of the magnet element 125 are embedded in the first substrate 130; or a depth of the hollow portion 135 is equal to a total height of the ferrite element 123 and the magnet element 125, to form a structure of a radio-frequency power amplifier module shown in FIG. 13C, where both the ferrite element 123 and the magnet element 125 are embedded in the first substrate 130.

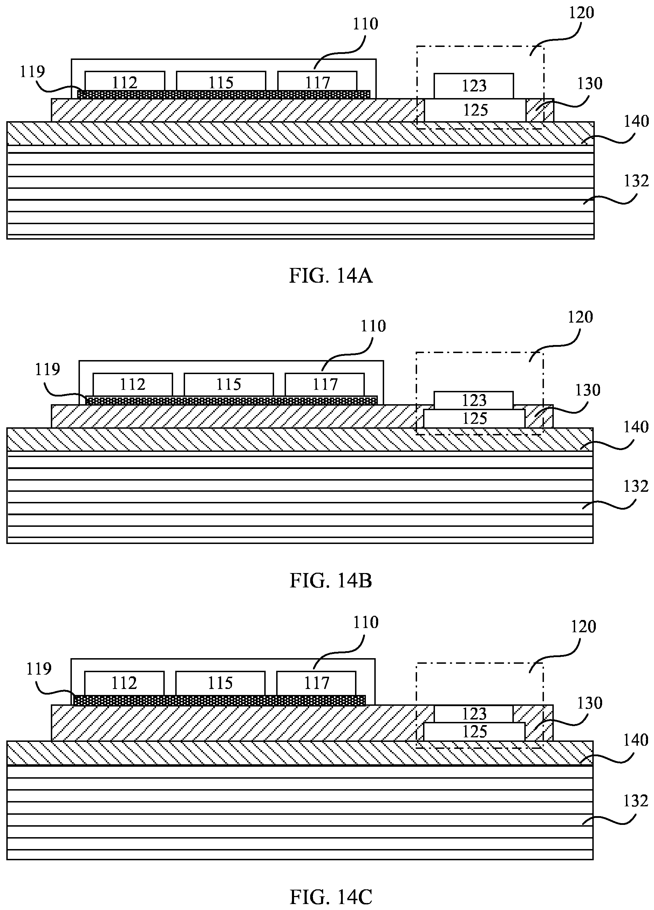

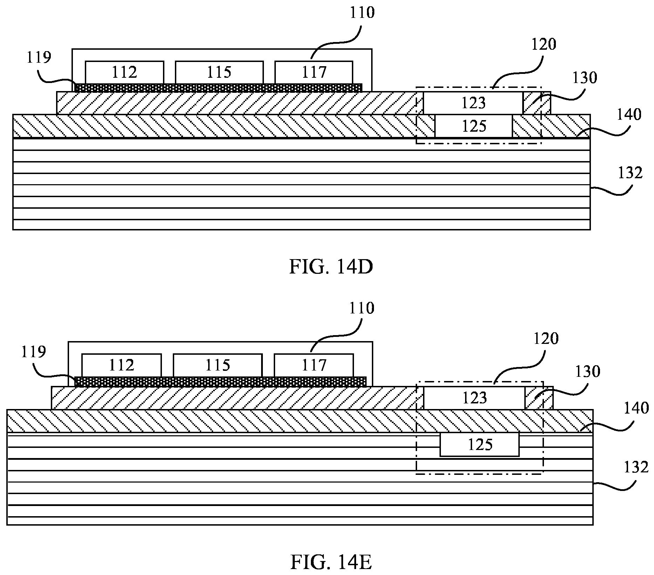

Similarly, a location of the magnet element 125 is not limited in embodiments of this application. The magnet element 125 may be provided above the ferrite element 123 in a stacked manner, or may be provided below the ferrite element 123. For example, the magnet element 125 is embedded in the first substrate 130, and the ferrite element 123 is provided above the magnet element 125 in a stacked manner. A hollow portion 135 is provided in the first region 133 of the first substrate 130, and the hollow portion 135 may at least accommodate a part of the magnet element 125, so that the magnet element 125 may be embedded in the first substrate 130. For example, a depth of the hollow portion 135 is less than or equal to a height of the magnet element 125, to form a structure of a radio-frequency power amplifier module shown in FIG. 14A, where at least a part of the magnet element 125 is embedded in the first substrate 130; or a depth of the hollow portion 135 is greater than a height of the magnet element 125, but is less than a total height of the ferrite element 123 and the magnet element 125, to form a structure of a radio-frequency power amplifier module shown in FIG. 14B, where the entire magnet element 125 and a part of the ferrite element 123 are embedded in the first substrate 130; or a depth of the hollow portion 135 is equal to a total height of the ferrite element 123 and the magnet element 125, to form a structure of a radio-frequency power amplifier module shown in FIG. 14C, where both the ferrite element 123 and the magnet element 125 are embedded in the first substrate 130. In another example, regardless of whether the ferrite element 123 is provided on a surface of the first region 133 of the first substrate 130 or is embedded in the first substrate 130, the magnet element 125 may be alternatively embedded in the second substrate 140, to form a structure of a radio-frequency power amplifier module shown in FIG. 14D; or the magnet element 125 may be alternatively embedded in the heat dissipation layer 132, to form a structure of a radio-frequency power amplifier module shown in FIG. 14E, provided that the magnet element 125 can provide a stable magnetic field for the ferrite element 123.

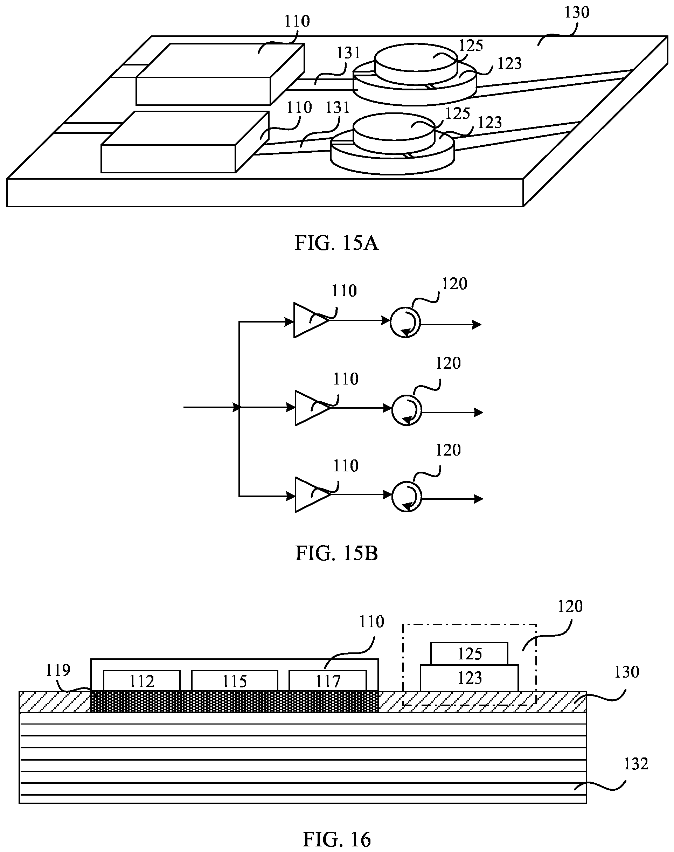

In embodiments of this application, quantities of power amplifier components 110 and isolation components 120 are not limited. For example, in a radio-frequency power amplifier module shown in FIG. 15A, a plurality of power amplifier components 110 and a plurality of isolation components 120 are integrated in the radio-frequency power amplifier module. The power amplifier components 110 are in one-to-one correspondence with the isolation components 120, so that a plurality of radio-frequency paths are integrated in one radio-frequency power amplifier module, to form a power amplifier circuit shown in FIG. 15B.

The following further describes the radio-frequency power amplifier module in the foregoing embodiments by using a metal-substrate power amplifier module as an example.

Refer to a diagram of a structure of a radio-frequency power amplifier module shown in FIG. 16. The metal-substrate radio-frequency power amplifier module includes a heat dissipation layer 132 and a first substrate 130 that is provided on the heat dissipation layer 132 in a stacked manner. A power amplifier component 110 and an isolation component 120 are provided on the first substrate 130. The power amplifier component 110 is electrically connected to the isolation component 120 through the first substrate 130. The isolation component 120 includes a ferrite element 123, a magnet element 125, and a first region 133 of the first substrate 130. The magnet element 125 is provided on the ferrite element 123 in a stacked manner. The ferrite element 123 is provided on a surface of the first region 133 of the first substrate 130. A first connection circuit is provided in the first region 133 of the first substrate 130, and the first connection circuit is configured to be connected to another part of the isolation component.

The following further describes the radio-frequency power amplifier module in the foregoing embodiments by using an inverted power amplifier module as an example.

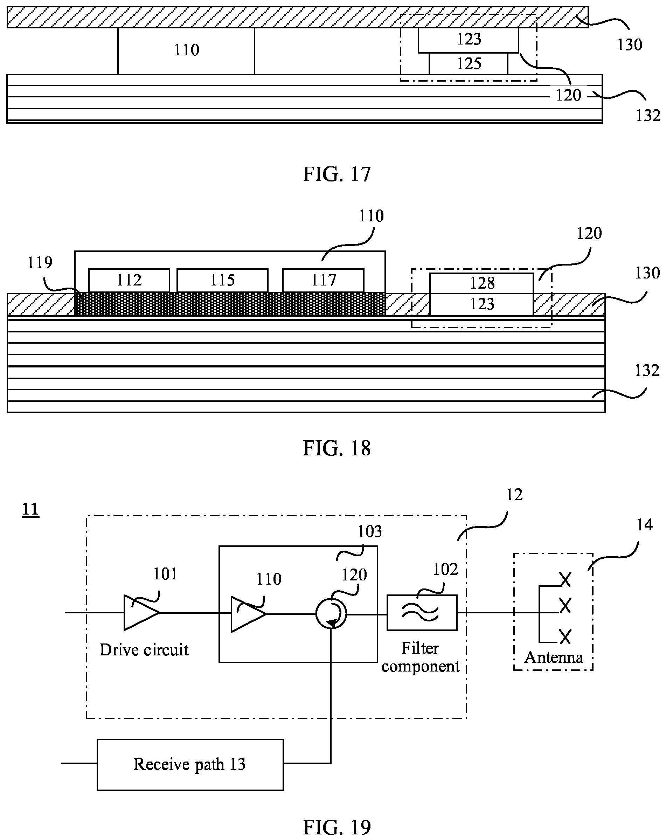

Refer to a diagram of a structure of a radio-frequency power amplifier module shown in FIG. 17. The inverted radio-frequency power amplifier module includes a heat dissipation layer 132 and a first substrate 130. A power amplifier component 110 and an isolation component 120 are provided on the first substrate 130. The heat dissipation layer 132 is provided on a side of the power amplifier component 110 away from the first substrate 130. The power amplifier component 110 is electrically connected to the isolation component 120 through the first substrate 130. The isolation component 120 includes a ferrite element 123, a magnet element 125, and a first region 133 of the first substrate 130. The magnet element 125 is provided on the ferrite element 123 in a stacked manner. The ferrite element 123 is provided on an upper surface of the first region of the first substrate 130. A first connection circuit is provided in the first region 133 of the first substrate 130, and the first connection circuit is configured to be connected to another part of the isolation component, for example, the first connection circuit is electrically connected to the ferrite element 123.

It should be noted that, when the radio-frequency power amplifier module is the metal-substrate power amplifier module or the inverted power amplifier module, the power amplifier component 110 in the radio-frequency power amplifier module may be a discrete component or an integrated component. In addition, a location of the magnet element 125 in the radio-frequency power amplifier module is not limited in embodiments of this application, and the magnet element 125 may be provided above or below of the ferrite element 123, provided that a projection of the magnet element 125 on the first substrate 130 at least partially overlaps a projection of the ferrite element 123 on the first substrate 130.

In another embodiment, refer to a diagram of a structure of a radio-frequency power amplifier module shown in FIG. 18. The radio-frequency power amplifier module may be of a spin wave structure, so that a magnet element 125 may not be provided in an isolation component 120, and only a coating layer 128 needs to be provided on a surface of a ferrite element 123. A radio-frequency circuit is provided in the coating layer 128, and the radio-frequency circuit is electrically connected to a first connection circuit in a first region 133 of a first substrate 130, so that an input radio-frequency signal can flow only in a specific direction.

Embodiments of this application further provide an antenna transceiver module 11. Refer to a diagram of a structure of an antenna transceiver module shown in FIG. 19. The antenna transceiver module 11 includes a transmit path 12, a receive path 13, and an antenna 14. The transmit path 12 is electrically connected to the antenna 14, and the receive path 13 is electrically connected to the antenna 14. The transmit path 12 includes the radio-frequency power amplifier module 103 provided in the foregoing embodiments.

For example, the transmit path further includes a drive circuit 101 and a filter component 102. An output end of the drive circuit 101 is electrically connected to an input end of the radio-frequency power amplifier module 103, and an output end of the radio-frequency power amplifier module 103 is electrically connected to the filter component 102.

The drive circuit 101 sends a received digital baseband signal to the radio-frequency power amplifier module 103, and adjusts the digital baseband signal, to ensure that the digital baseband signal can be completely sent. The radio-frequency power amplifier module 103 performs gain on the digital baseband signal, and modulates the digital baseband signal into a radio-frequency signal. The radio-frequency signal obtained through modulation has features such as high power, high efficiency, and low distortion, to achieve an optimal transmission effect. Filtering is performed by the filter component 102 on the radio-frequency signal obtained through modulation, to avoid interference to a peripheral device. Finally, the radio-frequency signal is transmitted by the antenna after passing through the filter component 102 in a forward direction. In addition, because an isolation component 120 is further integrated in the radio-frequency power amplifier module 103, the radio-frequency power amplifier module 103 may further avoid deterioration of the power amplifier component 110 because the radio-frequency power amplifier module 103 prevents an interference signal reflected from a load end, such as the filter component 102 or the antenna 14, from affecting performance of the power amplifier component 110, and may further reduce impact of a reflected signal on a digital pre-distortion (digital pre-distortion, DPD) forward correction signal.

In this embodiment of this application, the isolation component 120 is directly integrated in the radio-frequency power amplifier module 103, so that costs of the radio-frequency power amplifier module 103 can be effectively decreased, thereby decreasing costs of the antenna transceiver module 11. In addition, in the radio-frequency power amplifier module 103, a cabling distance between the isolation component 120 and the power amplifier component 110 is shortened, and an insertion loss between the power amplifier component 110 and the isolation component 120 is reduced. In this way, an area of the antenna transceiver module can be reduced, and transmission efficiency of the antenna transceiver module can be improved.

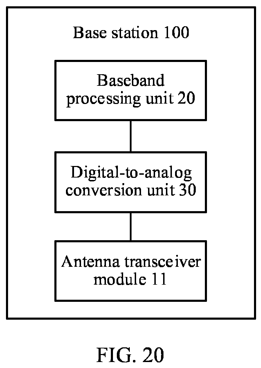

Refer to FIG. 20. An embodiment of this application further provides a base station 100. The base station 100 includes a baseband processing unit 20, a digital-to-analog conversion unit 30, and at least one antenna transceiver module 11 provided in the foregoing embodiment. The baseband processing unit 20 is connected to the antenna transceiver module 11 through the digital-to-analog conversion unit 30.

It may be understood that one or more antenna transceiver modules 11 may be provided in the base station 100. When a plurality of antenna transceiver modules 11 are provided in the base station, at least one of the plurality of antenna transceiver modules 11 is the antenna transceiver module 11 in the foregoing embodiment, thereby decreasing costs of the base station and improving transmission efficiency of the base station.

In the descriptions of this specification, the specific features, structures, materials, or characteristics may be combined in a proper manner in any one or more of embodiments or examples.

Finally, it should be noted that the foregoing embodiments are merely intended for describing the technical solutions of this application, but not for limiting this application. Although this application is described in detail with reference to the foregoing embodiments, a person of ordinary skill in the art should understand that modifications may still be made to the technical solutions described in the foregoing embodiments or equivalent replacements may be made to some technical features thereof, and such modifications and replacements do not cause the essence of the corresponding technical solutions to depart from the spirit and scope of the technical solutions of embodiments of this application.

## Claims

1. A radio-frequency power amplifier module, comprising a first substrate, and
a power amplifier component and an isolation component that are provided on the first substrate, wherein the power amplifier component is electrically connected to the isolation component through the first substrate; and
the isolation component comprises a ferrite element and a first region of the first substrate, and the ferrite element is provided in the first region of the first substrate.

2. The radio-frequency power amplifier module according to claim 1, wherein the power amplifier component comprises a power amplifier chip and a second region of the first substrate, and the power amplifier chip is provided in the second region of the first substrate.

3. The radio-frequency power amplifier module according to claim 1 or 2, wherein the isolation component further comprises a dielectric unit, the dielectric unit is of a ring structure, and the dielectric unit is nested around the ferrite element.

4. The radio-frequency power amplifier module according to any one of claims 1 to 3, wherein the isolation component further comprises a magnet element, the magnet element is provided on a side of the ferrite element, and a projection of the magnet element on the first substrate at least partially overlaps a projection of the ferrite element on the first substrate.

5. The radio-frequency power amplifier module according to claim 4, wherein the radio-frequency power amplifier module further comprises a second substrate, the second substrate is located on a side of the first substrate away from the power amplifier component, and the second substrate is electrically connected to the first substrate.

6. The radio-frequency power amplifier module according to claim 4, wherein the radio-frequency power amplifier module further comprises a heat dissipation layer, and the heat dissipation layer is located on a side of the first substrate away from the power amplifier component.

7. The radio-frequency power amplifier module according to any one of claims 1 to 5, wherein the radio-frequency power amplifier module further comprises a heat dissipation layer, and the heat dissipation layer is located on a side of the power amplifier component away from the first substrate.

8. The radio-frequency power amplifier module according to claim 5, wherein the magnet element is embedded in the second substrate.

9. The radio-frequency power amplifier module according to claim 6, wherein the magnet element is embedded in the heat dissipation layer.

10. The radio-frequency power amplifier module according to claim 4, wherein the magnet element is embedded in the first substrate, and provided on a side of the ferrite element close to the first substrate.

11. The radio-frequency power amplifier module according to any one of claims 1 to 6, wherein the ferrite element and the power amplifier component are provided on the first substrate, and are located on a same side of the first substrate.

12. The radio-frequency power amplifier module according to any one of claims 1 to 6, wherein the ferrite element is embedded in the first substrate.

13. The radio-frequency power amplifier module according to claim 1, wherein the ferrite element is embedded in the first substrate, and a coating layer is provided on the ferrite element.

14. The radio-frequency power amplifier module according to any one of claims 2 to 13, wherein the power amplifier component further comprises an input matching circuit and an output matching circuit; and
the input matching circuit and the output matching circuit are provided in the second region of the first substrate, an input end of the power amplifier chip is electrically connected to the input matching circuit, and an output end of the power amplifier chip is electrically connected to the output matching circuit.

15. The radio-frequency power amplifier module according to claim 1, wherein the power amplifier component comprises a power amplifier chip, an input matching circuit, an output matching circuit, and a package substrate, wherein the power amplifier chip, the input matching circuit, and the output matching circuit are provided on the package substrate, an input end of the power amplifier chip is electrically connected to the input matching circuit, and an output end of the power amplifier chip is electrically connected to the output matching circuit.

16. A manufacturing method for a radio-frequency power amplifier module, comprising: separately forming a first substrate, a power amplifier component, and an isolation component, wherein the first substrate comprises a first region, the isolation component comprises a ferrite element, and the ferrite element is provided in the first region of the first substrate; and
electrically connecting the power amplifier component to the first substrate.

17. An antenna transceiver module, comprising a receive path, a transmit path, and an antenna, wherein the transmit path is electrically connected to the receive path and the antenna separately, and the transmit path comprises the radio-frequency power amplifier module according to any one of claims 1 to 15.

18. A base station, comprising a baseband processing unit, a digital-to-analog conversion unit, and at least one antenna transceiver module according to claim 17, wherein the baseband processing unit is connected to the antenna transceiver module through the digital-to-analog conversion unit.
